# EUROPÄISCHE PATENTSCHRIFT

(11) **EP 2 654 078 B1**
(45) Veröffentlichungstag und Bekanntmachung des Hinweises auf die Patenterteilung: **21.09.2016**
(21) Anmeldenummer: 13163736.5
(22) Anmeldetag: 15.04.2013
(51) Int. Cl.: H01L 23/367

(54) **Halbleiterbauelement-Verbundstruktur mit Wärmeableitstruktur und dazugehöriges Herstellungsverfahren**
Composite semiconductor construction element structure with heat-dissipating structure and method of manufacturing the same
Structure composite d'élément semi-conducteur avec structure d'évacuation de la chaleur et procédé de fabrication correspondant

(30) Priorität: 17.04.2012 DE 102012206289
(43) Veröffentlichungstag der Anmeldung: 23.10.2013
(73) Patentinhaber: Forschungsverbund Berlin e.V., 12489 Berlin (DE)
(72) Erfinder: Krämer, Tomas, 10245 Berlin (DE)
(74) Vertreter: Gulde & Partner

(56) Entgegenhaltungen:
- WO-A1-03/081669
- US-A1- 2007 035 011
- US-A1- 2008 315 398
- US-A1- 2010 164 093

## Beschreibung

Die vorliegende Erfindung betrifft eine Wärmeableitungsstruktur für elektrisch diskrete, integrierte Halbleiterbauelemente sowie ein dazugehöriges Herstellungsverfahren.

### Stand der Technik

Ein grundlegendes Problem in der Halbleitertechnologie besteht darin, dass sich beim Betrieb von integrierten Funktionselementen (Bauelement) wie z.B. Transistoren, Halbleiterlasern oder Dioden ein nicht zu vernachlässigender Betrag an Wärmeenergie (auch Bauteilwärme genannt) entwickelt. Überschreitet der Betrag an entwickelter Wärme im und um das Bauelement herum einen gewissen Grenzwert, kann dies zu der allmählichen oder abrupten Degradation beziehungsweise zur Zerstörung des integrierten Bauelements oder gar der gesamten Schaltung führen. Mit wachsendem Bedarf an höherer Ausgangsleistung, kontinuierlich voranschreitender Miniaturisierung der Bauelemente und steigenden Packungsdichten gewinnt das Problem der unerwünschten Wärmeentwicklung zunehmend an Bedeutung.

Aus dem Stand der Technik sind mehrere verschiedene Ansätze bekannt, die sich der Aufgabe widmen, über unterschiedlich geartete Aufbauten beziehungsweise Schichtabfolgen und Schichtstrukturierungen innerhalb von Halbleiterbauelement-Schichtstrukturen, eine Abfuhr der Wärme weg von den integrierten Bauelementen zu ermöglichen. Oft werden dazu sogenannte Wärmeverteiler beziehungsweise alternativ oder ergänzend sogenannte Wärmesenken verwendet, in welche die Abwärme von den Bauelementen bzw. den empfindlicheren Teilen der integrierten Schaltung abgeführt wird.

So ist beispielsweise aus der US 2007/0035011 A1 ein integrierter Schaltkreis bekannt, der eine Vielzahl an elektrisch und thermisch leitenden "vias" (vertical interconnect accesses) umfasst, an die eine elektrisch isolierende Wärmeleitschicht chemisch "gebonded" ist, welche eine Wärmeabfuhr ermöglicht, ohne die einzelnen vias untereinander zu verbinden. Die Wärmeleitschicht kann dabei beispielsweise metallisiert sein oder aus einer Diamantschicht bestehen.

Aus der JP 2689986 B2 ist ein Substrat für einen aus mehreren Schichten bestehenden Schaltkreis bekannt, mit welchem der thermische Widerstand des Substrats eines Schaltkreises verringert und gleichzeitig dessen Vermögen, Wärme abzuleiten, erhöht werden kann. Das Substrat des aus mehreren Schichten bestehenden Schaltkreises umfasst ein auf einer Diamantschicht basierendes Ausgangssubstrat, mehrere Kontaktierungsschichten sowie diamantbasierte Zwischenschichten zur elektrischen Isolation.

Aus der US 7,286,359 B2 ist eine Wärmeableitstruktur für einen mikroelektronischen Schaltkreis bekannt, welcher auf einem Ausgangssubstrat angeordnete Schaltkreiselemente umfasst, die lokal hitzeproduzierende Bereiche aufweisen, welche über Durchkontaktierungen, welche durch eine thermisch isolierende Schicht hindurchgeführt sind, thermisch an eine Wärmeableitschicht angebunden sind.

Ferner sind aus der US 2006/0205161 A1 ein Herstellungsverfahren für ein Halbleiterbauelement sowie Halbleiterbauelemente bekannt, welche eine Vielzahl an Source-Gate-Drain-Kombinationen aufweisen, welche für den Betrieb bei hohen Frequenzen auf einem hohen Leistungsniveau ausgebildet sind und in welchen Maßnahmen beziehungsweise Mittel zur Hitzeableitung vorgesehen sind.

In der DE 10 2008 063 416 A1 ist ein Halbleiterbauelement mit einem Substrat offenbart, wobei über dem Substrat eine Halbleiterschicht gebildet ist, die ein beliebiges geeignetes Halbleitermaterial repräsentiert, um darin und darüber Schaltungselemente herzustellen, welche in einer Bauteilebene angeordnet sind. Innerhalb des Halbleiterbauelementes liegt eine vergrabene, isolierende Schicht, welche die Bauteilebene von dem Substrat trennt. Zwecks Wärmeableitung in den temperaturkritischen Bereichen des Halbleiterbauelementes werden in der DE 10 2008 063 416 A1 sich über die gesamte Höhe des Halbleiterbauelementes erstreckende Öffnungen beziehungsweise Gräben geätzt, welche mit einem Füllmaterial aufgefüllt werden. Das Füllmaterial bildet dann je Öffnung ein Wärmeableitelement. Ferner kann jeweils am unteren Ende der Öffnungen ein Materialpropfen angeordnet sein, um das Füllmaterial einzuschließen.

### Offenbarung der Erfindung

Erfindungsgemäß wird eine Halbleiterbauelement-Verbundstruktur bereitgestellt, die ein Ausgangssubstrat mit diskreten, integrierten Bauelementen und eine Wärmeableitstruktur aufweist. Die Wärmeableitstruktur umfasst eine Bondschicht, die auf dem Ausgangssubstrat oder den Bauelementen aufgebracht ist, eine Wärmeableitschicht, die auf der Bondschicht aufgebracht ist und aus einem Material mit einer mindestens doppelt so hohen spezifischen Wärmeleitfähigkeit, wie die durchschnittliche spezifische Wärmeleitfähigkeit des Ausgangssubstrats oder der Bauelemente besteht, und eine oder mehrere metallische Wärmebrücken, welche die Bauelemente mit der Wärmeableitschicht durch die Bondschicht thermisch verbinden.

Die Wärmebrücken sind als senkrechte Durchverbindungen (Vias) durch die Bond- und Wärmeableitschicht ausgebildet. Eine solche Ausführungsform lässt sich auf besonders einfache Art und Weise herstellen, da für die Realisierung der Wärmebrücken keine gesonderten beziehungsweise aufwändigen Strukturen geschaffen werden müssen und somit im Bereich der Halbleitertechnik standardisierte und bekannte Verfahren zur Schaffung der Durchverbindungen genutzt werden können.

Nach dem Stand der Technik wäre es zu erwarten, dass der oben beschriebene Schichtaufbau, welcher als wesentliches Element der Wärmeableitstruktur eine schlecht wärmeleitende Bondschicht inkludiert, ungeeignet für eine ausreichende Abfuhr der Bauteilwärme und damit zur Lösung des oben geschilderten Problems der Wärmeentwicklung ist. Wider Erwarten hat sich gezeigt, dass durch die Kombination einer schlecht wärmeleitenden Bondschicht mit einer gut wärmeleitenden Wärmeableitschicht sowie der Installation von diskreten Wärmebrücken, welche im Wesentlichen die integrierten Bauelemente thermisch mit der Wärmeableitschicht verbinden, eine Abfuhr der Bauteilwärme in gegenüber dem Stand der Technik vorteilhafter Weise erfolgen kann. Dabei ermöglicht die laterale Durchstrukturierung des Bondmediums mit vertikalen Wärmebrücken durch eine funktionale Trennung die gleichzeitige Optimierung sowohl des gebondeten Verbundstrukturaufbaus von Bauelement mit Wärmeableitschicht als auch die des Wärmeübergangs über das Bondmedium hinweg. Der Vorteil ergibt sich dabei zum einen aus der direkten, sehr platzsparenden und diskreten Anbindung der Bauelemente an die Wärmeableitschicht und zum anderen aus deren Vermögen, große Wärmemengen von den einzelnen Bauelementen separat abzuführen. Die Wärmebrücken können dabei ebenfalls als Verbindungen zur diskreten, elektrischen Kontaktierung der integrierten Bauelemente realisiert und verwendet werden. Die Wärmeableitschicht selbst ist in der Regel als angenähert planare Schicht in Bezug auf die Abmessungen der Bauelemente ausgeführt, die abgesehen von den Kontaktlöchern für die Durchverbindungen (Vias), beziehungsweise der Wärmebrücken, vorzugsweise eine geringe laterale Strukturierung aufweist, um die Wärmespreizung innerhalb der Wärmeableitschicht nicht unnötig einzuschränken. Der Verbund von Bauelementen und Wärmeableitschicht ist einfach zu prozessieren und für die Massenproduktion tauglich. Dies gilt insbesondere für die Wärmeableitschicht selbst, die Herstellung des Verbunds über das Bondmedium als auch das Etablieren der separaten thermischen Vias von den Bauelementen zur Wärmesenke.

Im Zuge der Fertigung, welche im Rahmen eines sogenannten "Wafer Level Packagings" parallel für jedes Bauelement erfolgen kann, wird bei einer möglichen Fertigungsvariante das Ausgangssubstrat mit den integrierten Bauelementen ganzflächig, das heißt über den gesamten Wafer, mit einer Bondschicht überzogen. Im Anschluss daran wird der gesamte Wafer über die Bondschicht, mit einer Wärmeableitschicht, die optional auf einem Trägersubstrat aufgebracht ist, verbunden, zum Beispiel verklebt. Das Trägersubstrat, sofern vorhanden, wird entfernt und die Bondschicht sowie die Wärmeableitschicht strukturiert. Eine hohe spezifische Wärmeleitfähigkeit der Wärmeableitschicht wird angestrebt, die sich bei gegebenen thermischen Anforderungen in reduzierten Materialdicken und damit in einer geringeren Vias-Topologie niederschlägt. Zusammen mit deren guter Strukturierbarkeit kann eine Prozessführung innerhalb ausgereifter etablierter Verfahren der Halbleiterchipfertigung (Frontend) gewahrt werden, die eine parallele Prozessierung der Bauelemente bei gleichzeitiger hoher Ausrichtungspräzision (<2 µm), Auflösung (<5 µm) und Formtreue (<1 µm) gewährleisten, wie sie für hohe Integrationsdichten und für Höchstfrequenzanwendungen notwendig sind. Zusammen mit dem Viasprozess können die Wärmeableitungsschichten vereinzelt, das heißt in freier Trennlinienführung mit hochpräzisen Kanten im Vergleich zu den sonst üblichen geradlinigen Sägestraßenverfahren voneinander getrennt werden. Bei gleichzeitiger Vereinzelung der Halbleiterchips mit entsprechend hoch präzisen Kanten gestatten sehr kurze Mikrostreifen-Brückenstrukturen von wenigen 10 Mikrometern und Strukturauflösung von einigen Mikrometern nahezu nahtlose elektrische Übergänge über Chipgrenzen hinweg selbst bei Betriebsfrequenzen >100GHz.

Die Bondschicht ist direkt oder vorzugsweise über eine Haftvermittlerschicht auf dem Ausgangssubstrat beziehungsweise den Bauelementen aufgebracht.

Vorzugsweise ist die spezifische Wärmeleitfähigkeit der Wärmeableitschicht mindestens 3-mal so hoch wie die durchschnittliche spezifische Wärmeleitfähigkeit des Ausgangssubstrats, insbesondere der Halbleiterschichten des Bauelements. Eine solche Realisierung erhöht das Wärmeleitvermögen der Wärmeableitstruktur und ermöglicht die Abfuhr großer Wärmemengen, wie sie bei Leistungsbauelementen, wie beispielsweise Diodenlasern oder Leistungstransistoren, oder bei dicht gepackten Bauelementen, wie zum Beispiel in integrierten Schaltungen, auftreten.

In einer bevorzugten Ausführungsform ist die spezifische Wärmeleitfähigkeit der Wärmeableitschicht ≥ 250Wm⁻¹K⁻¹. Insbesondere besteht die Wärmeableitschicht in Teilen oder vollständig aus Kohlenstoff mit einer Diamantstruktur (zum Beispiel wie in US 2007/0035011 A1 und JP 2689986 B2 ausgeführt) oder aus Siliziumkarbid (SiC).

Vorzugsweise weist die Wärmeableitschicht eine Schichtdicke im Bereich von 1 µm bis 1000 µm auf, im Speziellen 5 bis 20 µm.

In einer bevorzugten Ausführungsform besteht die Wärmeableitschicht in Teilen oder vollständig aus Kohlenstoff mit einer Diamantstruktur. Solche Stoffe weisen eine hohe Wärmeleitfähigkeit auf, sind trockenchemisch gut strukturierbar und lassen sich vorteilhaft, beispielsweise über das Verfahren der chemischen Gasphasenabscheidung (CVD), als Schicht realisieren. Der geringe Materialbedarf der Diamant-Schicht, der nötig ist, um den thermischen und mechanischen Anforderungen gerecht zu werden, führt zu niedrigen Vias-Topologien, die zusammen mit deren guter Strukturierbarkeit eine Prozessierung innerhalb etablierter Verfahren der Halbleiterfertigung ermöglicht.

Vorzugsweise weist die Bondschicht eine Schichtdicke im Bereich von 50 nm bis 50 µm auf, im Speziellen 1 bis 3 µm. Vorteil einer solchen Ausführung ist die durch sie ermöglichte, kompakte Bauweise, durch welche Kosten, Prozessaufwand und Platz eingespart werden. Mit kürzeren Wärmebrücken verringert sich neben der Vias-Topologie auch der Wärmewiderstand zwischen Bauelement und Wärmeableitschicht.

In einer bevorzugten Ausführungsform weist die Bondschicht eine spezifische Wärmeleitfähigkeit ≤ 5 Wm⁻¹K⁻¹ auf. Die Bondschicht selbst soll möglichst wenig Wärme aufnehmen, da diese direkt an den integrierten Bauelementen liegt und als thermische Isolation zwischen den Bauelementen und der Wärmesenke fungiert.

Vorzugsweise besteht die Bondschicht aus einem organischen Polymer. Organische Polymere lassen sich gut in definierter Dicke über wenig aufwändige Verfahren, wie beispielsweise das "spin coating", abscheiden. Organische Polymere eignen sich zudem besonders gut zum Wafer Bonding.

In einer bevorzugten Ausführungsform besteht die Bondschicht aus einem Polymer auf Basis von Benzocyclobuten (BCB). BCB eignet sich besonders gut zum Wafer Bonding und dient der Ausbildung einer robusten Verbindung zwischen der Wärmeableitschicht und dem Substrat mit den integrierten Bauelementen (spezifische Wärmeleitfähigkeit BCB = 0,3 Wm⁻¹K⁻¹).

In einer bevorzugten Ausführungsform bestehen die Wärmebrücken aus einem Metall oder einer Legierung, deren spezifische Wärmeleitfähigkeit ≥ 200Wm⁻¹K⁻¹ ist, wie z.B. Gold, Kupfer oder Aluminium.

Besonders bevorzugt ist eine Kombination aus einer Wärmeableitschicht, welche aus Kohlenstoff mit einer Diamantstruktur oder aus Siliziumkarbid besteht, mit einer aus Benzocyclobuten (BCB) bestehenden Bondschicht sowie mit Wärmebrücken in der vorhergehenden Ausführungsform. Eine derartige Kombination von Materialien ermöglicht die effiziente Ableitung sehr großer Wärmemengen. Außerdem lässt sich ein günstiges Verhältnis von der Wärmeableitung zu dem realisierten mechanischen Trägervolumen erzielen. Im Vergleich zu anderen Verbindungen ist mit der Anbindung der Wärmeableitschicht an das Substrat über das "BCB Wafer Bonding" sowie über die metallischen, im Speziellen galvanischen, Wärmebrücken eine robuste Verbindungstechnologie gegeben. Der Aufbau einer solchen Halbleiterbauelement-Schichtstruktur in der oben beschriebenen Ausführungsform ist dabei im gesamten Millimeterwellenbereich hoch- und höchstfrequenztauglich. Der dielektrische Verlustfaktor (auch "Tangens-Delta-Verlust" genannt) der Halbleiterbauelement-Schichtstruktur ist in der oben beschriebenen Ausführungsform sehr gering.

Vorzugsweise ist die Wärmeableitstruktur beidseitig der Bauelemente angeordnet. Durch eine solche "Sandwich-Struktur" wird die Ableitung der Wärme von den Bauelementen auf die Wärmeableitschicht noch weiter verbessert, da die Wärmebrücken die Bauteilwärme sowohl von der Vorder-, als auch der Rückseite der Bauelemente zu den Wärmeableitschichten hin abtransportieren. Im Folgenden ist dabei die Vorderseite der Bauelemente als die dem Ausgangssubstrat abgewendete Seite der Bauelemente definiert, während die Rückseite die gegenüberliegende, substratzugewandte Seite der Bauelemente ist.

In einer weiteren bevorzugten Ausführungsform deckt die Grundfläche einer Wärmebrücke mindestens 40% der jeweiligen Stirnfläche eines Bauelementes ab.

Ein weiterer Aspekt der Erfindung liegt in der Bereitstellung eines Verfahrens zur Herstellung der vorab beschriebenen Halbleiterbauelement-Verbundstruktur. Das Verfahren umfasst die Schritte:
Aufbringen einer Bondschicht auf dem Ausgangssubstrat oder den Bauelementen;
Aufbringen einer Wärmeableitschicht auf der Bondschicht, wobei die Wärmeableitschicht aus einem Material mit einer mindestens doppelt so hohen spezifischen Wärmeleitfähigkeit, wie die durchschnittliche spezifische Wärmeleitfähigkeit des Ausgangssubstrats oder der Bauelemente besteht; und

Bereitstellen von ein oder mehreren metallischen Wärmebrücken, welche die Bauelemente mit der Wärmeableitschicht durch die Bondschicht thermisch verbinden, wobei die Wärmebrücken als senkrechte Durchverbindungen (Vias) durch die Bond- und Wärmeableitschicht ausgebildet werden.

### Kurzbeschreibung der Figuren

Ausführungsbeispiele der Erfindung werden anhand von Zeichnungen und der nachfolgenden Beschreibung näher erläutert. Es zeigen:
- Figur 1: einen prinzipiellen Aufbau einer Ausführungsform der erfindungsgemäßen Halbleiterbauelement-Verbundstruktur mit Wärmeableitungsstruktur;
- Figur 2: einen prinzipiellen Aufbau einer erfindungsgemäßen Halbleiterbauelement-Verbundstruktur, bei der die Wärmeableitstruktur beidseitig der Bauelemente ausgeführt ist; und
- Figur 3: mehrere spezielle Fertigungsvarianten einer erfindungsgemäßen Halbleiterbauelement-Verbundstruktur mit Wärmeableitungsstruktur.

### Detaillierte Beschreibung der Erfindung

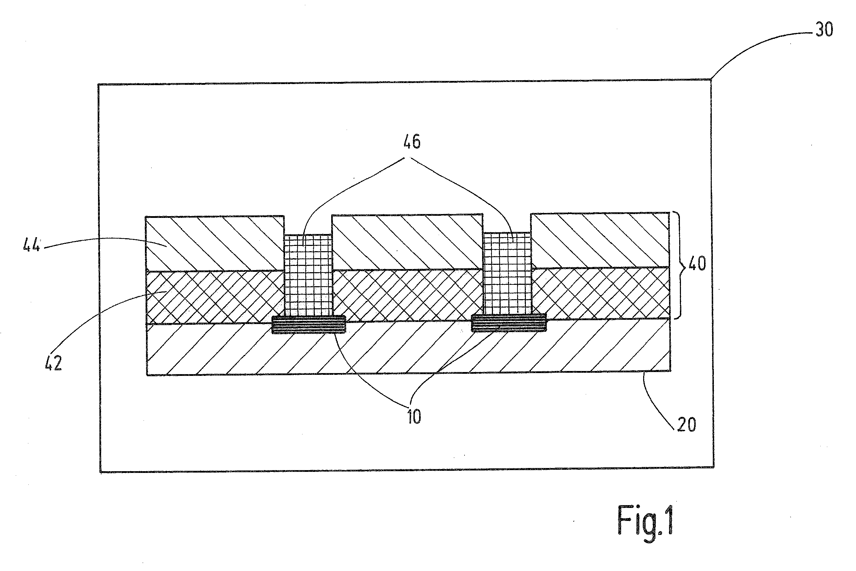

Figur 1 zeigt den prinzipiellen Aufbau einer Ausführungsform der erfindungsgemäßen Halbleiterbauelement-Verbundstruktur mit Wärmeableitungsstruktur 30. Auf der Vorderseite des Ausgangssubstrats 20 mit diskreten Bauelementen 10 ist eine Bondschicht 42 aufgebracht. Die Bondschicht 42 kann direkt oder vorzugsweise über eine Haftvermittlerschicht (nicht dargestellt) auf dem Ausgangssubstrat 20 beziehungsweise den Bauelementen 10 aufgebracht sein. Direkt auf der Bondschicht 42 befindet sich eine Wärmeableitschicht 44. Zur Verbindung der Wärmeableitschicht 44 mit den diskreten Bauelementen 10 sind mehrere, in der Figur 1, zwei, Wärmebrücken 46 etabliert. Für deren Implementierung wurden zunächst Hohl-Vias beziehungsweise Kontaktlöcher gefertigt, welche durch die Wärmeableitschicht 44 sowie die Bondschicht 42 geführt sind und zu den integrierten Bauelementen 10 hinreichen. Im Anschluss daran wurden die Hohl-Vias von der Oberfläche der integrierten Bauelemente 10 bis vorzugsweise über die halbe Dicke der Wärmeableitschicht 44 hinaus, mit Material befüllt. Die Wärmebrücken 46 stehen somit mit den integrierten Bauelementen 10 und der Wärmeableitschicht 44 in thermischem Kontakt. Damit ist die Wärmeableitschicht 44 thermisch auf kürzestem Wege durch die Bondschicht 42 an die integrierten Bauelemente 10 angebunden. Kommt es bei Betrieb der integrierten Bauelemente 10 zu einer Entwicklung von Wärmeenergie, wird diese über die Wärmebrücken 46 auf die als Wärmespreizer fungierende Wärmeableitschicht 44 abgeführt.

Die Bondschicht 42 kann aus polymerisiertem Benzocyclobuten und die Wärmeableitschicht 44 aus CVD-Diamant oder Siliziumkarbid bestehen. Für die Wärmebrücken 46 eignet sich insbesondere Gold, Kupfer oder Aluminium.

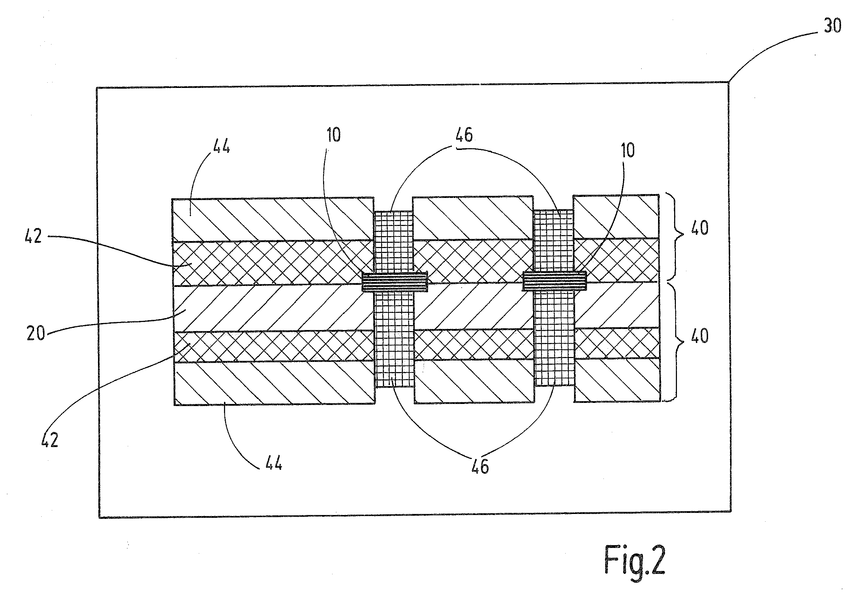

Figur 2 zeigt den prinzipiellen Aufbau einer erfindungsgemäßen Halbleiterbauelement-Verbundstruktur mit Wärmeableitungsstruktur 30, bei der die Wärmeableitstrukturen 40 auf beiden Seiten des Ausgangssubstrats 20 vorhanden sind. Eine solche Wärmeableitstruktur 40 wird auch "Sandwich-Struktur" genannt. In der in Figur 2 gezeigten, speziellen Ausführungsform, ist auf beiden Seiten der Bauelemente, das heißt bezüglich der Vordersowie Rückseite des Ausgangssubstrates 20, eine Bondschicht 42 aufgebracht. Auf den beiden Bondschichten 42 befindet sich jeweils eine Wärmeableitschicht 44. In diesem speziellen Ausführungsbeispiel sind die Vorderseiten der diskreten Bauelemente 10 über Wärmebrücken 46 mit der Wärmeableitschicht 44 thermisch verbunden, während die Rückseiten der diskreten Bauelemente 10 über metallische Wärmebrücken 46 mit der Wärmeableitschicht 44 durch das Ausgangssubstrat hindurch thermisch verbunden sind. Optional kann im Laufe des Prozesses das Ausgangssubstrat 20 auch vollständig entfernt werden, oder anstatt des Bauelementes 10 auch bloß das Ausgangssubstrat 20 rückseitig von der Wärmebrücke 46 thermisch ankontaktiert werden. Die metallischen Wärmebrücken 46 zur Vorderseite der Bauelemente sind in dem in Figur 2 gezeigten Beispiel als senkrechte Durchverbindungen (Vias), durch die Bond- und die Wärmeableitschicht 42, 44 ausgeführt, während die Wärmebrücken 46 zur Bauelemente-Rückseite zusätzlich noch durch das Ausgangssubstrat 20 führen. Sie werden gebildet durch ein Material, welches in diesem Ausführungsbeispiel von der Oberfläche der integrierten Bauelemente 10 ausgeht und mit dem Material der Wärmeableitschicht 44 in thermischem Kontakt steht. Auf diese Weise ist das integrierte Bauelement 10 beidseitig an jeweils eine Wärmeableitschicht 44 angeschlossen.

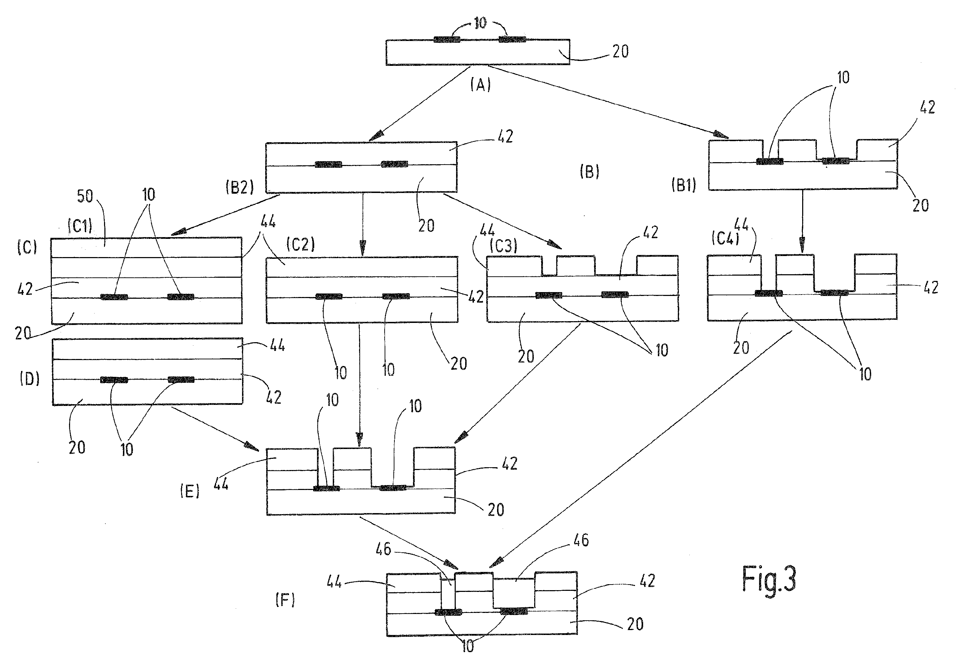

Figur 3 zeigt mehrere spezielle Fertigungsvarianten einer erfindungsgemäßen Halbleiterbauelement-Verbundstruktur 30. Diese Fertigungsvarianten stellen Alternativen zueinander dar. Ausgangspunkt aller Fertigungsvarianten ist dabei das Ausgangssubstrat 20 mit den integrierten Bauelementen 10 (Schritt A).

Dieses Ausgangssubstrat 20 kann beispielsweise aus Silizium oder einem III-V Halbleiter bestehen und speziell dotierte Bereiche aufweisen. Auf die Vorderseite des Ausgangssubstrates 20 wird zunächst die Bondschicht 42, zum Beispiel unter Verwendung des sogenannten "spin coating-Verfahrens" aufgebracht (Schritt B). Bei der Bondschicht kann es sich zum Beispiel um eine Schicht aus polymerisiertem Benzocyclobuten handeln, welche eine Dicke zwischen 50 nm bis 50 µm aufweist. Im Anschluss daran wird entweder die Bondschicht 42 vorstrukturiert, indem die integrierten Bauelemente 10, zumindest teilweise, freigelegt werden (Schritt B1) oder die Bondschicht bleibt zunächst unstrukturiert (Schritt B2) und es wird in einer zweiten Fertigungsvariante damit begonnen, die Wärmeableitschicht 44 aufzubringen und wahlweise vorzustrukturieren (Schritt C).

Die Wärmeableitschicht 44 weist insbesondere eine Dicke zwischen 1 und 1000 µm auf und besteht zum Beispiel vollständig aus Kohlenstoff, welcher eine Diamantstruktur aufweist. Dies kann auf mehrerlei Weise geschehen: In einer ersten Fertigungsvariante wird die Wärmeableitschicht 44 zunächst auf ein Trägersubstrat 50 aufgebracht, dann mit der Bondschicht 42 verbunden und zunächst nicht weiter behandelt (Schritt C1). In einer zweiten Fertigungsvariante wird die Wärmeableitschicht 44 ohne Trägersubstrat 50 direkt auf die Bondschicht 42 aufgebracht und verbleibt zunächst ebenfalls unbehandelt (Schritt C2). In einer dritten Fertigungsvariante wird die Wärmeableitschicht 44 mit oder ohne Trägersubstrat auf die Bondschicht 42 aufgebracht und vorstrukturiert, wobei die Bondschicht zunächst weitgehend unberührt bleibt (Schritt C3). In einer vierten Fertigungsvariante wird die Wärmeableitschicht 44 mit oder ohne Trägersubstrat auf die bereits vorstrukturierte Bondschicht 42 aufgebracht und mit der Bondschicht im Einklang stehend strukturiert (Schritt C4). Unabhängig von der Verwendung eines Trägersubstrates 50 können bei dem Schritt C auch Haftvermittlungsschichten zum Einsatz kommen, welche in Figur 3 nicht eingezeichnet sind.

Wurde ein Trägersubstrat 50 verwendet, wird dieses nach Beendigung des Bondprozesses entfernt (Schritt D). Nach Beendigung der im Schritt C4 vorgenommenen Strukturierung sind die Kontaktlöcher für die Wärmebrücken gefertigt. Nach Beendigung der Schritte D, C2 und C3 ist dies noch nicht (vollends) geschehen und wird in einem Schritt E durchgeführt. In dem hier vorliegenden Fall werden die Kontaktlöcher für die Wärmebrücken anisotrop und selektiv geätzt. Im Anschluss daran werden die Kontaktlöcher mit Material, in dem hier vorliegenden Fall, über die Dicke der Bondschicht 42 und bis über die halbe Dicke der Wärmeableitschicht 44 hinaus befüllt (Schritt F). Das die Wärmebrücken ausbildende Material steht also sowohl mit den integrierten Bauelementen 10 als auch mit der Wärmeableitschicht 44 in thermischem Kontakt. Es besteht in diesem Ausführungsbeispiel aus Gold.

Wenn die Wärmebrücken 46 installiert sind, kann das Fertigungsverfahren zur Erzeugung einer "Sandwich-Struktur", das heißt zur Erzeugung einer zweiten Wärmeableitstruktur 40 auf der Rückseite des Bauelements 10, wie es in Figur 2 dargestellt ist, wiederholt werden. Eine zweite Wärmeableitschicht 44 kann optional auch direkt auf die Rückseite des Ausgangssubstrats 20 aufgebracht werden.

## Patentansprüche

1. Eine Halbleiterbauelement-Verbundstruktur (30), die ein Ausgangssubstrat (20) mit diskreten, integrierten Bauelementen (10) und eine Wärmeableitstruktur (40) aufweist, wobei die Wärmeableitstruktur (40) umfasst:
eine Bondschicht (42), die auf dem Ausgangssubstrat (20) oder den Bauelementen (10) aufgebracht ist;
eine Wärmeableitschicht (44), die auf der Bondschicht (42) aufgebracht ist und aus einem Material mit einer mindestens doppelt so hohen spezifischen Wärmeleitfähigkeit, wie die durchschnittliche spezifische Wärmeleitfähigkeit des Ausgangssubstrats (20) oder der Bauelemente (10) besteht; und
eine oder mehrere metallische Wärmebrücken (46), welche die Bauelemente (10) mit der Wärmeableitschicht (44) durch die Bondschicht (42) thermisch verbinden, **dadurch gekennzeichnet, dass** die Wärmebrücken (46) als senkrechte Durchverbindungen (Vias) durch die Bond- und Wärmeableitschicht (42, 44) ausgebildet sind.

2. Halbleiterbauelement-Verbundstruktur (30) nach Anspruch 1, bei der die Bondschicht (42) über eine Haftvermittlerschicht auf dem Ausgangssubstrat (20) aufgebracht ist.

3. Halbleiterbauelement-Verbundstruktur (30) nach einem der vorhergehenden Ansprüche, bei der die spezifische Wärmeleitfähigkeit der Wärmeableitschicht (44) mindestens 3-mal so hoch ist wie die durchschnittliche spezifische Wärmeleitfähigkeit des Ausgangssubstrats (20).

4. Halbleiterbauelement-Verbundstruktur (30) nach einem der vorhergehenden Ansprüche, wobei die durchschnittliche spezifische Wärmeleitfähigkeit der Wärmeableitschicht (44) ≥ 250 Wm⁻¹K⁻¹ ist.

5. Halbleiterbauelement-Verbundstruktur (30) nach einem der vorhergehenden Ansprüche, wobei die Wärmeableitschicht (44) eine Schichtdicke im Bereich von 1 µm bis 1000 µm aufweist.

6. Halbleiterbauelement-Verbundstruktur (30) nach einem der vorhergehenden Ansprüche, bei der die Wärmeableitschicht (44) in Teilen oder vollständig aus Kohlenstoff mit einer Diamantstruktur oder Siliziumkarbid besteht.

7. Halbleiterbauelement-Verbundstruktur (30) nach einem der vorhergehenden Ansprüche, bei der die Bondschicht (42) eine Schichtdicke im Bereich von 50 nm bis 50 µm aufweist.

8. Halbleiterbauelement-Verbundstruktur (30) nach einem der vorhergehenden Ansprüche, bei der die Bondschicht (42) eine spezifische Wärmeleitfähigkeit ≤ 5 Wm⁻¹K⁻¹ aufweist.

9. Halbleiterbauelement-Verbundstruktur (30) nach einem der vorhergehenden Ansprüche, bei der die Bondschicht (42) aus einem organischen Polymer besteht.

10. Halbleiterbauelement-Verbundstruktur (30) nach Anspruch 9, bei der die Bondschicht (42) aus einem Polymer auf Basis von Benzocyclobuten besteht.

11. Halbleiterbauelement-Verbundstruktur (30) nach einem der vorhergehenden Ansprüche, bei der die Wärmebrücken (46) aus einem Metall oder einer Legierung bestehen, deren spezifische Wärmeleitfähigkeit ≥ 200 Wm⁻¹K⁻¹ ist.

12. Halbleiterbauelement-Verbundstruktur (30) nach Anspruch 11, bei der die Wärmebrücken (46) aus Gold, Kupfer oder Aluminium bestehen.

13. Halbleiterbauelement-Verbundstruktur (30) nach einem der vorhergehenden Ansprüche, bei der die Wärmeableitstruktur (40) beidseitig der Bauelemente auf deren Vorder- und Rückseite bezüglich des Ausgangssubstrates (20) angeordnet sind.

14. Halbleiterbauelement-Verbundstruktur (30) nach einem der vorhergehenden Ansprüche, wobei die Grundfläche einer metallischen Wärmebrücke (46) mindestens 40% der jeweiligen Stirnfläche eines Bauelementes (10) abdeckt.

15. Verfahren zur Herstellung einer Halbleiterbauelement-Verbundstruktur (30), die ein Ausgangssubstrat (20) mit diskreten, integrierten Bauelementen (10) und eine Wärmeableitstruktur (40) aufweist, wobei das Verfahren die Schritte umfasst:
Aufbringen einer Bondschicht (42) auf dem Ausgangssubstrat (20) oder den Bauelementen (10);
Aufbringen einer Wärmeableitschicht (44) auf der Bondschicht (42), wobei die Wärmeableitschicht (44) aus einem Material mit einer mindestens doppelt so hohen spezifischen Wärmeleitfähigkeit, wie die durchschnittliche spezifische Wärmeleitfähigkeit des Ausgangssubstrats (20) oder der Bauelemente (10) besteht; und
Bereitstellen von ein oder mehreren metallischen Wärmebrücken (46), welche die Bauelemente (10) mit der Wärmeableitschicht (44) durch die Bondschicht (42) thermisch verbinden, wobei die Wärmebrücken (46) als senkrechte Durchverbindungen (Vias) durch die Bond- und Wärmeableitschicht (42, 44) ausgebildet werden.

## Claims

1. A semiconductor device composite structure (30) which comprises an initial substrate (20) with discreet, integrated devices (10) and a heat removal structure (40), wherein the heat removal structure (40) comprises:
a bond layer (42) which is applied to the initial substrate (20) or to the devices (10);
a heat removal layer (44) which is applied to the bond layer (42) and consists of a material with at least double the specific heat conductivity of the average specific heat conductivity of the initial substrate (20) or the devices (10); and
one or more metallic thermal bridges (46) which thermally connect the devices (10) with the heat removal layer (44) via the bond layer (42), **characterized in that** the thermal bridges (46) are designed as vertical through connections (vias) through the bond and heat removal layer (42, 44).

2. The semiconductor device composite structure (30) according to Claim 1, wherein the bond layer (42) is applied to the initial substrate (20) using an adhesion promoter layer.

3. The semiconductor device composite structure (30) according to any one of the preceding claims, wherein the specific heat conductivity of the heat removal layer (44) is at least three times as high as the average specific heat conductivity of the initial substrate (20).

4. The semiconductor device composite structure (30) according to any one of the preceding claims, wherein the average specific heat conductivity of the heat removal layer (44) is ≥ 250 Wm⁻¹K⁻¹.

5. The semiconductor device composite structure (30) according to any one of the preceding claims, wherein the heat removal layer (44) has a layer thickness ranging from 1 µm to 1000 µm.

6. The semiconductor device composite structure (30) according to any one of the preceding claims, wherein the heat removal layer (44) partly or entirely consists of carbon with a diamond structure or silicon carbide.

7. The semiconductor device composite structure (30) according to any one of the preceding claims, wherein the bond layer (42) has a layer thickness ranging from 50 nm to 50 µm.

8. The semiconductor device composite structure (30) according to any one of the preceding claims, wherein the bond layer (42) has a specific heat conductivity of ≤ 5 Wm⁻¹K⁻¹.

9. The semiconductor device composite structure (30) according to any one of the preceding claims, wherein the bond layer (42) consists of an organic polymer.

10. The semiconductor device composite structure (30) according to Claim 9, wherein the bond layer (42) consists of a polymer based on benzocyclobutene.

11. The semiconductor device composite structure (30) according to any one of the preceding claims, wherein the thermal bridges (46) consist of a metal or alloy, the specific heat conductivity of which is ≥ 200 Wm⁻¹K⁻¹.

12. The semiconductor device composite structure (30) according to Claim 11, wherein the thermal bridges (46) consist of gold, copper or aluminum.

13. The semiconductor device composite structure (30) according to any one of the preceding claims, wherein the heat removal structure (40) is arranged on both sides of the devices on their front and rear side in relation to the initial substrate (20).

14. The semiconductor device composite structure (30) according to any one of the preceding claims, wherein the base area of a metallic thermal bridge (46) covers at least 40% of the respective front surface of a device (10).

15. A method for producing a semiconductor device composite structure (30) which comprises an initial substrate (20) with discreet, integrated devices (10) and a heat removal structure (40), wherein the method comprises the steps of:
applying a bond layer (42) to the initial substrate (20) or the devices (10);
applying a heat removal layer (44) to the bond layer (42), wherein the heat removal layer (44) consists of a material with at least double the specific heat conductivity of the average specific heat conductivity of the initial substrate (20) or the devices (10); and
providing one or more metallic thermal bridges (46) which thermally connect the devices (10) with the heat removal layer (44) via the bond layer (42), wherein the thermal bridges (46) are designed as vertical through connections (vias) through the bond and heat removal layer (42, 44).

## Revendications

1. Structure composite de composants à semi-conducteurs (30) comportant un substrat de base (20) avec des composants (10) discrets intégrés et une structure de dissipation de chaleur (40), où la structure de dissipation de chaleur (40) comprend :
une couche de liaison (42) appliquée sur le substrat de base (20) ou les composants (10) ;
une couche de dissipation de chaleur (44) appliquée sur la couche de liaison (42) et composée d'un matériau ayant une conductivité thermique spécifique au moins deux fois plus élevée que la conductivité thermique spécifique moyenne du substrat de base (20) ou des composants (10) ; et
un ou plusieurs ponts thermiques (46) métalliques reliant thermiquement les composants (10) à la couche de dissipation de chaleur (44) au travers de la couche de liaison (42), **caractérisée en ce que** les ponts thermiques (46) sont réalisés comme connexions traversantes verticales (Vias) au travers de la couche de liaison et de la couche de dissipation de chaleur (42, 44).

2. Structure composite de composants à semi-conducteurs (30) selon la revendication 1, où la couche de liaison (42) est appliquée sur le substrat de base (20) au moyen d'une couche d'adhésif.

3. Structure composite de composants à semi-conducteurs (30) selon l'une des revendications précédentes, où la conductivité thermique spécifique de la couche de dissipation de chaleur (44) est au moins trois fois plus élevée que la conductivité thermique spécifique moyenne du substrat de base (20).

4. Structure composite de composants à semi-conducteurs (30) selon l'une des revendications précédentes, où la conductivité thermique spécifique moyenne de la couche de dissipation de chaleur (44) est supérieure ou égale à 250 Wm⁻¹K⁻¹.

5. Structure composite de composants à semi-conducteurs (30) selon l'une des revendications précédentes, où la couche de dissipation de chaleur (44) a une épaisseur comprise entre 1 µm et 1000 µm.

6. Structure composite de composants à semi-conducteurs (30) selon l'une des revendications précédentes, où la couche de dissipation de chaleur (44) est composée en partie ou en totalité de carbone avec une structure de diamant, ou de carbure de silicium.

7. Structure composite de composants à semi-conducteurs (30) selon l'une des revendications précédentes, où la couche de liaison (42) a une épaisseur comprise entre 50 nm et 50 µm.

8. Structure composite de composants à semi-conducteurs (30) selon l'une des revendications précédentes, où la couche de liaison (42) a une conductivité thermique spécifique inférieure ou égale à 5 Wm⁻¹K⁻¹.

9. Structure composite de composants à semi-conducteurs (30) selon l'une des revendications précédentes, où la couche de liaison (42) est constituée d'un polymère organique.

10. Structure composite de composants à semi-conducteurs (30) selon la revendication 9, où la couche de liaison (42) est constituée d'un polymère à base de benzocyclobutène.

11. Structure composite de composants à semi-conducteurs (30) selon l'une des revendications précédentes, où les ponts thermiques (46) sont en métal ou en alliage dont la conductivité thermique spécifique est supérieure ou égale à 200 Wm⁻¹K⁻¹.

12. Structure composite de composants à semi-conducteurs (30) selon la revendication 11, où les ponts thermiques (46) sont en or, en cuivre ou en aluminium.

13. Structure composite de composants à semi-conducteurs (30) selon l'une des revendications précédentes, où la structure de dissipation de chaleur (40) est disposée sur les deux côtés des composants, sur leur face avant et leur face arrière par rapport au substrat de base (20).

14. Structure composite de composants à semi-conducteurs (30) selon l'une des revendications précédentes, où la surface de base d'un pont thermique (46) métallique couvre au moins 40% de la surface frontale d'un composant (10) correspondant.

15. Procédé de fabrication d'une structure composite de composants à semi-conducteurs (30) comportant un substrat de base (20) avec des composants (10) discrets intégrés et une structure de dissipation de chaleur (40), ledit procédé comprenant les étapes suivantes :
application d'une couche de liaison (42) sur le substrat de base (20) ou les composants (10) ;
application d'une couche de dissipation de chaleur (44) sur la couche de liaison (42), la couche de dissipation de chaleur (44) étant en matériau ayant une conductivité thermique spécifique au moins deux fois plus élevée que la conductivité thermique spécifique moyenne du substrat de base (20) ou des composants (10) ; et
préparation d'un ou de plusieurs ponts thermiques (46) reliant thermiquement les composants (10) à la couche de dissipation de chaleur (44) au travers de la couche de liaison (42), lesdits ponts thermiques (46) étant réalisés comme connexions traversantes verticales (Vias) au travers de la couche de liaison et de la couche de dissipation de chaleur (42, 44).
